Europäisches Patentamt

European Patent Office

Office européen des brevets

(11) Publication number: **0 515 025 A1**

# EUROPEAN PATENT APPLICATION

(21) Application number: **92302723.9**

(22) Date of filing: **27.03.92**

(51) Int. Cl.⁵: **H01L 27/148**, H01L 31/0232, H01L 31/0216

(30) Priority: **20.05.91 US 702489**

(43) Date of publication of application:
**25.11.92 Bulletin 92/48**

(84) Designated Contracting States:
**DE FR GB**

(71) Applicant: **TEKTRONIX INC.**
**Howard Vollum Park 14150 S.W. Karl Braun**
**Drive P.O.Box 500, Mail Stop 50-PAT**
**Beaverton Oregon 97077-0001(US)**

(72) Inventor: **Blouke, Morley M.**
**14980 N.W. Oak Hills Drive**
**Beaverton, Oregon 97006(US)**
Inventor: **Heidtmann, Denis L.**
**7820 S.W. Walnut Lane**
**Portland, Oregon 97225(US)**

(74) Representative: **Wombwell, Francis et al**
**Potts, Kerr & Co. 15, Hamilton Square**
**Birkenhead Merseyside L41 6BR(GB)**

(54) **Enhanced long wavelength response for thinned CCD devices.**

(57) A thinned charge-coupled device (CCD) (10) with enhanced long wavelength response is formed by coating the active imaging area (14) with a metal film (20) to form a mirror for photons incident on the back side of the device that pass through the device. Those photons are reflect4ed back through the epitaxial substrate to increase the probability of absorption.

Fig.3

## Background of the Disclosure

The present invention relates to charge-coupled devices (CCD), and more particularly to a method and structure for producing enhanced long wavelength response for thinned CCD devices.

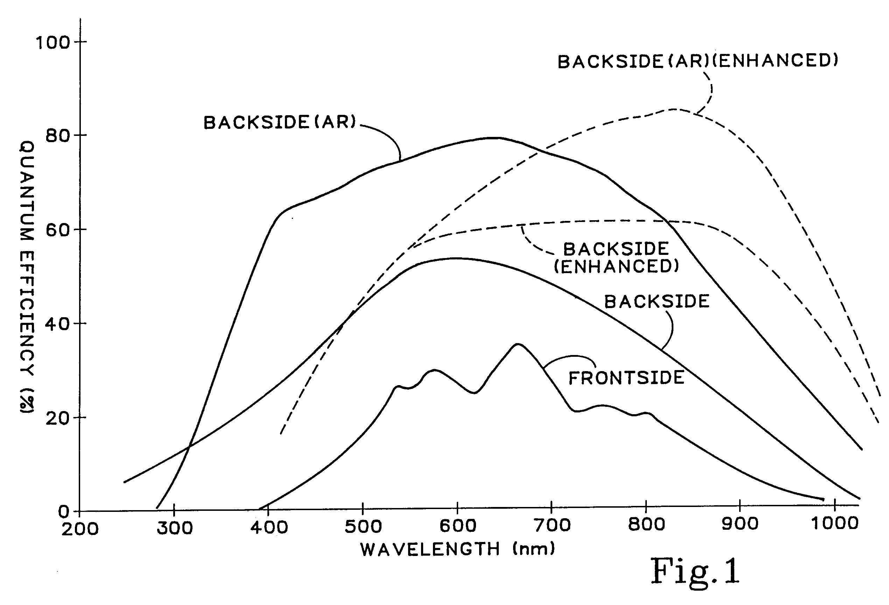

One of the great virtues of CCD devices is the enormous range of wavelengths to which the device responds with high quantum efficiency. Fig. 1 shows the typical quantum efficiency response for several CCD device structures, including a frontside illuminated device, a backside illuminated device and a backside illuminated device having an anti-reflective (AR) coating. The short wavelength response of the frontside illuminated device is severely curtailed for wavelengths shorter than 450 nm. This low sensitivity is well understood, and is due to the absorption of incident photons in the polysilicon gates that make up the electrode structure on the front side of the device. Therefore backside illuminated devices are used, especially thinned backside illuminated devices, to minimize the absorption of the shorter wavelengths prior to interacting with the depletion area of the CCD gates. As shown this increases the short wavelength response down to approximately 300 nm. The anti-reflective coating at the photon incident surface reduces the number of photons that are reflected from the device without entering the epitaxial material, so that at 400 nm quantum efficiencies approaching 70% may be achieved.

At long wavelengths (>700 nm) the absorption coefficient of silicon decreases to the point where some of these long wavelength photons pass through the device without being absorbed. This also reduces the quantum efficiency of the device, as shown by the curves of Fig. 1. In fact there exists an important laser spectral line at approximately 1.06 microns (1,064 nm) where the response of the device without any enhancement is again severely curtailed. To enhance the response at these long wavelengths, several modifications to the typical CCD device process have been made. These include using a higher resistivity material for the depletion region in order to increase the depletion depth beneath the electrode gates, and using thicker epitaxial material to give the long wavelength photons more material within which to be absorbed. All of these processes were used to achieve the enhanced long wavelength response as shown by the dotted curves in Fig. 1. However, this is achieved at the expense of curtailing the short wavelength response.

The major contribution to the long wavelength response shown for the enhanced thinned device is the substantially thicker epitaxial material (50 microns) than is normally used (10-20 microns). The major liability of using such thicker epitaxial material is the fact that substantial resolution is lost due to lateral diffusion of the photogenerated carriers. This is especially a problem when one has a device with small pixels (<15 microns$^2$) and thick epitaxial material, since the small pixel size is desired for high precision scientific devices requiring high resolution.

What is desired is an enhanced long wavelength response for thinned CCD devices that preserves the devices' range of wavelengths and resolution.

## Summary of the Invention

Accordingly the present invention provides a simple method of enhancing the long wavelength response of a thinned charge-coupled device (CCD) without requiring thicker epitaxial material. A metal film is deposited over the entire imaging area of the device on the electrode gate side of the device, which deposition may be performed at the same time as the normal device metallization. The metal film, which is appropriately insulated from the gate metal interconnections, acts as a mirror to reflect the long wavelength photons so that they traverse the epitaxial material at least twice, greatly enhancing the probability that they will be absorbed and contribute to the resulting signal output of the device.

The objects, advantages and other novel features of the present invention are apparent from the following detailed description when read in conjunction with the appended claims and attached drawing.

## Brief Description of the Drawing

Fig. 1 is a graph of quantum efficiency response versus wavelength of prior art CCD devices.

Fig. 2 is a top plan view of a CCD device with enhanced long wavelength response according to the present invention.

Fig. 3 is a cross-sectional view of a portion of the CCD device shown in Fig. 2.

## Description of the Preferred Embodiment

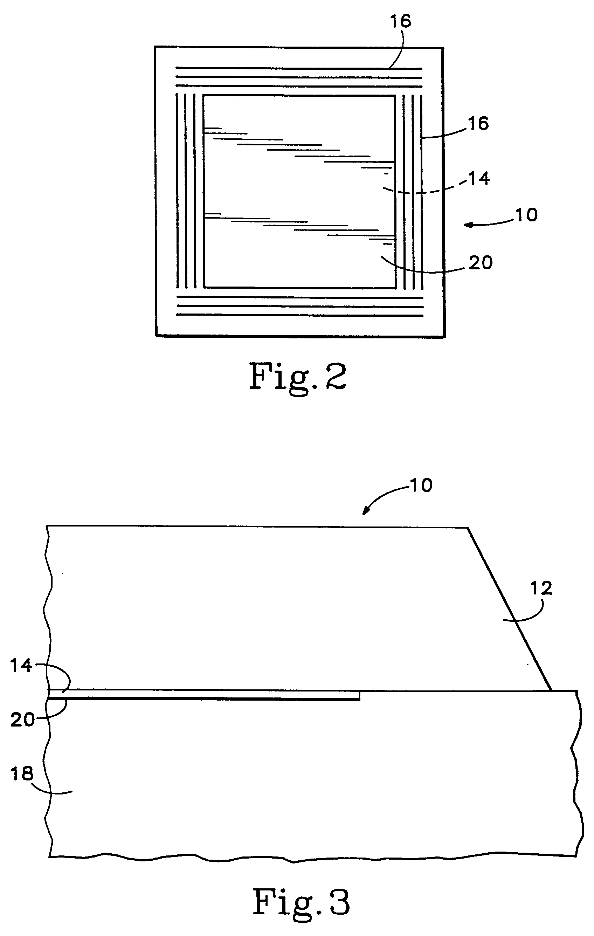

Referring now to Figs. 2 and 3 a thinned CCD device 10 is shown. An epitaxial substrate 12 has formed thereon an active imaging area 14 together with metal busses 16 that connect to the CCD registers, as is well known in the art. The active imaging area 14 contains the gate electrodes. Over the entire front side, i.e., gate electrode side, is formed a transparent reinforcing substrate 18 to provide rigidity for the CCD device 10. The steps for forming a thinned CCD device using a reinforcing material is further detailed in U.S. Patent No. 4,946,716, issued August 7, 1990 to Brian L. Corrie entitled "Method of Thinning a Silicon Wafer Using a Reinforcing Material." Preferably during the metallization step in the fabrication process of the CCD device 10 a metal film 20 is formed to coat the entire active imaging area 14. The metal film 20 is appropriately insulated from the gate metal interconnections. This metal film 20 acts as a mirror to reflect those long wavelength photons that manage to pass completely through the CCD device 10 without being absorbed.

The reflection of the long wavelength photons causes these photons to traverse the epitaxial substrate 12 at least twice, greatly enhancing their probability of being absorbed. Since the metal film 20 is physically close to the CCD device, the transmitted photons are reflected back through the same pixels, reducing the chance for degrading the resolution. As the metal film 20 is on the gate side of the CCD device 10, it does not interfere with any anti-reflective coatings that might be applied to the structure on the back side. Therefore at short wavelengths the metal film 20 has no effect so that the CCD device 10 behaves the same as shown in Fig. 1 for short wavelengths.

Although the present invention is described in terms of thinned CCD devices, it is equally applicable to any thinned optical sensors, such as photodiodes, CIDs, etc.

Thus the present invention provides a thinned CCD device structure with enhanced long wavelength response without requiring a thicker epitaxial substrate or degrading wavelength response and resolution by forming a metal film over the active imaging area of the device on the gate side to reflect long wavelength photons back through the epitaxial substrate again.

**Claims**

1. A thinned optical sensor semiconductor device (10) of the type having a thinned epitaxial substrate with an electrode gate structure on one side, the device further comprising a metal film (20) overlaying the electrode gate side (14) for reflecting photons incident on the side of the thinned epitaxial substrate opposite the electrode gate structure side back through the thinned epitaxial gate structure to increase the probability of absorption of incident long wavelength photons.

2. A method of manufacturing a thinned optical sensor semiconductor device (10) of the type having a thinned epitaxial substrate with an electrode gate structure on one side together with metal interconnect busses, the method including the step of coating a thin film of metal (20) over the electrode gate structure (14) during a metallization step that forms the metal interconnect busses to form a mirror on the electrode gate structure side that reflects photons incident on the side of the thinned epitaxial substrate opposite the electrode gate structure side back through the thinned epitaxial gate structure to increase the probability of absorption of incident long wavelength photons.

Fig.1

EP 0 515 025 A1

Fig.2

Fig.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | IEEE TRANSACTIONS ON ELECTRON DEVICES. vol. ED-32, no. 8, August 1985, NEW YORK US pages 1574 - 1583; J.R.TOWER ET AL.: 'Shortwave infrared 512x2 line sensor for earth resources applications' * page 1574, right column; figure 1 * | 1,2 | H01L27/148 H01L31/0232 H01L31/0216 |
| X | IEEE TRANSACTIONS ON ELECTRON DEVICES. vol. ED-32, no. 8, August 1985, NEW YORK US pages 1564 - 1573; W.F.KOSONOCKY ET AL.: '160x244 element PtSi Schottky-barrier IR-CCD image sensor' * page 1564 - page 1568; figure 6 * | 1,2 | |
| A | DE-A-2 715 471 (SIEMENS) * page 3, line 21 - page 5, line 4; figure 1 * | 1,2 | |
| A | IEEE TRANSACTIONS ON ELECTRON DEVICES. vol. ED-25, no. 2, February 1978, NEW YORK US pages 247 - 253; J.MÜLLER: 'Thin silicon film p-i-n photodiodes with internal reflection' * page 247 - page 248; figure 1 * | 1,2 | TECHNICAL FIELDS SEARCHED (Int. Cl.5) |
| D,A | US-A-4 946 716 (B.L.CORRIE) * column 3, line 15 - column 4, line 53; figures 1-3 * | 1,2 | H01L |

-----

The present search report has been drawn up for all claims

| Place of search | Date of completion of the search | Examiner |
|---|---|---|
| BERLIN | 29 JULY 1992 | MUNNIX S. |